Europäisches Patentamt

European Patent Office

Office européen des brevets

(11) Veröffentlichungsnummer: **0 111 799**
**B1**

(19)

(12) **EUROPÄISCHE PATENTSCHRIFT**

(45) Veröffentlichungstag der Patentschrift:
22.07.87

(51) Int. Cl.⁴: **G 03 F 7/26**

(21) Anmeldenummer: 83112161.1

(22) Anmeldetag: 03.12.83

(54) **Verfahren zur Entwicklung von Reliefstrukturen auf der Basis von strahlungsvernetzten Polymervorstufen hochwärmebeständiger Polymere.**

(30) Priorität: 15.12.82 DE 3246403

(43) Veröffentlichungstag der Anmeldung:
27.06.84 Patentblatt 84/26

(45) Bekanntmachung des Hinweises auf die Patenterteilung:
22.07.87 Patentblatt 87/30

(84) Benannte Vertragsstaaten:
AT CH DE FR GB LI NL

(56) Entgegenhaltungen:
EP-A-0 064 222

IBM TECHNICAL DISCLOSURE BULLETIN, Band 20, Nr. 5, Oktober 1977, Seite 1743, New York, USA, J.R. KITCHER: "Electron-beam resist development process"
IBM TECHNICAL DISCLOSURE BULLETIN, Band 17, Nr. 11, April 1975, Seite 3283, New York, USA, G.T. CHIU: "Developers for polysulfone terpolymer resists"

Die Akte enthält technische Angaben, die nach dem Eingang der Anmeldung eingereicht wurden und die nicht in dieser Patentschrift enthalten sind.

(73) Patentinhaber: Merck Patent Gesellschaft mit beschränkter Haftung, Frankfurter Strasse 250, D-6100 Darmstadt (DE)

(72) Erfinder: Merrem, Hans-Joachim, Dr., Grüner Weg 1, D-6104 Seeheim (DE)
Erfinder: Neisius, Karlheinz, Dr., Kattreinstrasse 76, D-6100 Darmstadt (DE)
Erfinder: Klug, Rudolf, Dr., Grünewaldstrasse 25, D-8750 Aschaffenburg (DE)
Erfinder: Härtner, Hartmut, Dr., Mathildenweg 9, D-6109 Mühltal (DE)

# 0 111 799

**Beschreibung**

Die Erfindung betrifft ein neues verbessertes Entwicklungsverfahren zur Ausbildung von Reliefstrukturen auf der Basis von strahlungsvernetzten Polyimidvorstufen hochwärmebeständiger Polyimide denen strahlungsempfindliche Fotolacke zugrunde liegen.

Fotolacke zur Ausbildung von Reliefstrukturen aus hochwärmebeständigen Polymeren werden in großem Umfang bei der Herstellung elektrischer und elektronischer Bauelemente, von Ätzreserven und Galvanikreserven oder von Druckformen verwendet. Eines der genauesten Strukturierungsverfahren für Isolierstoffe, Halbleiter- und Leiterwerkstoffe in der Elektrotechnik und Elektronik ist die Fototechnik. Hierbei werden fototechnisch erzeugte Resist-Reliefstrukturen durch geeignete Prozesse, wie Ätzen, Bedampfen und stromloses oder galvanisches Metallisieren, auf Substrate kopiert.

Resist-Reliefstrukturen können weiterhin auch eine dauerhafte Schutzfunktion, beispielsweise als Isolierstoff, übernehmen.

Aus beispielsweise den Patentschriften DE-PS 2 308 830, DE-PS 2 437 348, DE-PS 2 437 368 und DE-PS 2 437 422 sowie den deutschen Patentanmeldungen DE-P 32 27 584 und DE-P 32 33 912 sind Verfahren zur Herstellung solcher Reliefstrukturen aus hochwärmebeständigen Polymeren und für diese Zwecke geeignete Fotolacke bzw. die dazu verwendeten fotoempfindlichen löslichen polymeren Vorstufen bekannt.

Fotolacke der beschriebenen Art enthalten in der Regel strahlungsempfindliche lösliche polymere Vorstufen. Sie werden auf ein Substrat in Form einer Schicht oder Folie aufgetragen, die Schicht oder Folie wird getrocknet und dann durch eine Negativvorlage bestrahlt. An den bestrahlten Stellen findet dadurch eine Vernetzung statt, die die Löslichkeit des aufgetragenen Materials dort drastisch verringert. Die nicht bestrahlten Schicht- oder Folienteile werden dann mit Hilfe eines Entwicklers durch Herauslösen oder Abziehen entfernt; die verbleibenden Reliefstrukturen können dann durch Tempern in hochwärmebeständige Polymere überführt werden, die Temperaturen von 250 - 400° C ohne nachteilige Auswirkung auf Kantenschärfe und Auflösung überstehen.

Als lösliche Polymer-Vorstufen werden Polyadditions- oder Polykondensationsprodukte polyfunktioneller carbocyclischer oder heterocyclischer, strahlungsempfindliche Reste tragender Verbindungen mit Diaminen, Diisocyanaten, bis-Säurechloriden oder Dicarbonsäuren verwendet, wie sie in den zitierten Patentschriften beschrieben sind.

Besonders bevorzugt als lösliche polymere Vorstufen sind Polykondensate aus Pyromellithsäure, die zwei esterartig an Carboxylgruppen gebundene strahlungsreaktive Reste trägt, und einem mindestens ein cyclisches Strukturelement enthaltenden Diamin, wie beispielsweise 4,4'-Diamino diphenylether, 4,4'-Diaminodiphenylmethan, 4,4'-Diamino-diphenylsulfon, 2,4-Diaminopyridin.

Solche in Fotolacken verwendeten löslichen polymeren Vorstufen haben in der Regel Molekulargewichte zwischen 2000 und 100 000, vorzugsweise zwischen 4000 und 60 000.

Diese löslichen polymeren Vorstufen werden in an sich bekannter Weise zu den entsprechenden Fotolacken verarbeitet, die außer einem geeignetem Lösungsmittel bzw. Lösungsmittelgemisch gegebenenfalls noch in dieser Technologie bekannte und übliche Zusatzstoffe, wie Fotosensibilisatoren, Fotoinitiatoren, copolymerisierbare strahlungsreaktive Monomere oder Harze, Haftvermittler, Weichmacher sowie Pigmente, Farb- und Füllstoffe enthalten können.

Der Auftrag der Fotolacke auf die saubere Oberfläche der Substrate kann in der im Einzelfall vorteilhaften Schichtstärke durch Aufsprühen, Fließbeschichten, Walzen, Schleuderbeschichten und Tauchbeschichten erfolgen, wonach das Lösungsmittel durch Verdampfen entfernt wird, so daß auf der Oberfläche des Substrats eine strahlungsempfindliche Schicht zurückbleibt. Die Entfernung des Lösungsmittels kann gegebenenfalls durch Erhitzen der Schicht auf Temperaturen von bis zu 100° C gefördert werden. Anschließend wird die Fotolackschicht der Strahlung ausgesetzt, welche die Reaktion der strahlungsreaktiven Gruppen unter Vernetzung der Schicht verursacht. Die Bestrahlung oder Belichtung kann durch eine Maskenvorlage durchgeführt werden, es kann aber auch ein gebündelter Strahl über die Oberfläche der strahlungsempfindlichen Schicht geführt werden. Üblicherweise werden zur Bestrahlung UV-Lampen verwendet, die Strahlung einer Wellenlänge von 200 bis 500 nm und eine Intensität von 0,5 bis 60 mW/cm$^2$ aussenden. In der Schicht wird nun ein Bildmuster unter Freilegung von Teilen des Substrats entwickelt, in dem die Schicht mit einer Entwicklerlösung behandelt wird, die die nicht bestrahlten Bereiche des Fotolackmaterials entfernt. Die Resistbilder erhält man nach üblichem Waschen und Trocknen.

Dem Verfahrensschritt der Entwicklung kommt nun in der Herstellung strahlungsvernetzter Fotoresiststrukturen besondere Bedeutung zu, da hierbei Auflösung und Kantenschärfe der zurückbleibenden Resiststrukturen sowie deren Haftung auf dem Substrat und deren Materialeigenschaften wesentlich beeinflußt werden.

Ein guter Entwickler soll die nicht bestrahlten, löslichen Polymerschichten vom Substrat in kurzer, praxisgerechter Zeit entfernen. Dabei soll Anlösen und Abtragen der vernetzten Lackschichten und dadurch bedingter Schichtdickenverlust möglichst gering gehalten werden. Außerdem sollen Bestandteile des Entwicklers möglichst wenig in die vernetzten Polymerschichten eindringen, da damit Aufquellen der vernetzten Lackschicht sowie Haftungsverringerung auf dem Substrat verbunden ist. Weiterhin wird angestrebt, ein praxisgerechtes Entwicklungsverfahren, d. h. Gewährung eines möglichst weiten zeitlichen Entwicklungsspielraums, in dem bei einer Abtragung von vernetztem Polymermaterial in noch tolerierbarem Rahmen die vollständige Entfernung von nicht vernetztem Lack gewährleistet ist.

2

Als Entwicklerlösungen werden nach dem Stand der Technik Gemische verwendet, die aus einem oder mehreren der für die Herstellung des Fotolackes üblichen Lösungsmittel und einem bei der Herstellung der polymeren Vorstufe des Fotolackes üblicherweise verwendeten Fällungsmittel bestehen. Typische bekannte Entwicklerlösungen sind beispielsweise 4-Butyrolacton/Toluol, Dimethylformamid/Ethanol, Dimethylformamid/Methanol, Methylethylketon/ Ethanol und Methyl-i-butylketon/i-Propanol jeweils im Verhältnis 2 : 1 bis 4 : 1, wobei die jeweils erstgenannten Substanzen Lösungsmittel sind, die jeweils zweitgenannten Fällungsmittel repräsentieren. Üblich ist nach der Entwicklung ein Spülen mit dem Fällungsmittel, das lediglich dazu dient, den Entwickler restlos zu entfernen.

Ketone allein als Entwickler wurden bisher nur für spezielle Polymere wie Methacrylsäure - Methylmethacrylat-Polymer (IBM, Techn.Discl.Bull.20, No.5, 1977, S.1743, New York), Terpolymere auf der Basis von Polysulfonen (IBM, Techn.Discl.Bull.17, No.11, S.3283, 1975, New York) oder Fluoralkyl-α-chloracrylat-Polymere (EP-A 64 222) beschrieben.

Nachteile solcher Entwicklerlösungen nach dem Stand der Technik sind deren immer mehr oder minder ausgeprägte Aggressivität gegenüber den vernetzten Polymerschichten die sich in einem Schichtabtrag, Aufquellen der Schicht und Verringerung der Haftung auf dem Substrat sowie einem engen zeitlichen Entwicklungsspielraum manifestieren. Zur Herabsetzung dieser Aggressivität setzte man bisher der Entwicklerflüssigkeit neben dem Lösungsmittel stets ein Fällungsmittel zu.

Aufgabe der Erfindung ist es, ein verbessertes Verfahren zur Entwicklung von Reliefstrukturen auf der Basis von strahlungsvernetzten Polymervorstufen hochwärmebeständiger Polymere bereitzustellen, das die geschilderten Anforderungen erfüllt und nicht die obengenannten Nachteile der Entwickler gemäß dem Stand der Technik aufweist.

Diese Aufgabe wurde erfindungsgemäß nun gelöst durch ein Entwicklungsverfahren, bei dem als Entwickler ein aliphatisches oder cycloaliphatisches Keton mit 3 bis 7 Kohlenstoffatomen in Abwesenheit eines gemäß dem Stand der Technik sonst zugesetzten Fällungsmittels verwendet wird.

Gegenstand der Erfindung ist somit ein Verfahren zur Entwicklung von Reliefstrukturen auf der Basis von strahlungsvernetzten Polyimidvorstufen hochwärmebeständiger Polyimide mit einer Entwicklerflüssigkeit und gegebenfalls nachfolgender Behandlung mit einer Spülflüssigkeit, das dadurch gekennzeichnet ist, daß als Entwickler ein aliphatisches oder cycloaliphatisches Keton mit 3 bis 7 Kohlenstoffatomen in Abwesenheit eines Fällungsmittels verwendet wird.

Gegenstand der Erfindung ist weiterhin die Verwendung eines aliphatischen oder cycloaliphatischen Ketons mit 3 bis 7 Kohlenstoffatomen als Entwickler für Reliefstrukturen auf der Basis von strahlungsvernetzten Polyimidvorstufen hochwärmebeständiger Polyimide.

Als erfindungsgemäße Entwicklerflüssigkeiten eignen sich gerad- oder ungeradkettige aliphatische und cycloaliphatische bzw. alkylsubstituierte cycloaliphatische Ketone mit 3 bis 7 Kohlenstoffatomen, wie z. B. Aceton, Methylethylketon, Methylisopropylketon, Methylisobutylketon, Methyltertiärbutylketon, Cyclopentanon, Cyclohexanon, Cycloheptanon, 2- oder 3-Methyl- bzw. Ethylcyclopentanon, 2-, 3- oder 4-Methylcyclohexanon.

Bevorzugt sind Aceton, Methylethylketon, Cyclopentanon und Cyclohexanon, von denen wiederum Aceton und Cyclopentanon besonders bevorzugt sind. Verschiedene dieser Ketone sind zwar früher schon als Lösungsmittel für Fotolacke genannt worden. Es war jedoch nicht vorherzusehen, daß gerade diese Verbindungen ohne Zusatz eines Fällungsmittels alle an einen Entwickler gestellten Anforderungen so gut erfüllen und sich in so hervorragender Weise als Entwickler für Reliefstrukturen auf Basis von strahlungsvernetzten Vorstufen insbesondere hochwärmebeständiger Polyimide eignen.

Besonders vorteilhaft läßt sich das erfindungsgemäße Entwicklungsverfahren gestalten, wenn nach der Entwicklung die Reste der Entwicklerflüssigkeit mit einer Spülflüssigkeit entfernt werden.

Im Prinzip eignen sich alle mit dem Entwickler mischbaren Fällungsmittel als Spülflüssigkeiten. Bevorzugt sind gerad- oder ungeradkettig aliphatische Alkohole mit 1 bis 4 Kohlenstoffatomen; insbesondere eignen sich Ethanol, Propanol und Isopropanol.

Das erfindungsgemäße Entwicklungsverfahren für strahlungsvernetzte Polyimid-Fotoresiststrukturen bzw. die erfindungsgemäße Verwendung der genannten Ketone ermöglicht eine schnelle und restlose Entfernung der nicht bestrahlten löslichen Polymerschichten vom Substrat aus. Insbesondere zeichnet sich das neue Verfahren durch ein Minimum an Aggressivität gegenüber den vernetzten Polymerschichten aus, wie es von Entwicklern nach dem Stand der Technik, denen zum Zweck der Verringerung der Aggressivität eigens ein Fällungsmittel zugesetzt wird, nicht erreicht wird. Der Schichtabtrag an den vernetzten Polymerschichten gegenüber Entwicklern nach dem Stand der Technik ist beim erfindungsgemäßen Verfahren erheblich reduziert; ein Aufquellen der Schichten und eine damit verbundene Haftungsverringerung auf dem Substrat wird vermieden. Überraschenderweise ermöglicht das erfindungsgemäße Verfahren zudem einen deutlich erweiterten zeitlichen Entwicklungsspielraum ohne negativen Einfluß auf die vernetzten Polymerschichten.

Die gegenüber den Inhaltsstoffen der Entwickler gemäß dem Stand der Technik weitaus geringere Toxizität der in dem erfindungsgemäßen Verfahren verwendeten Flüssigkeiten verringert darüber hinaus eine gesundheitliche Beeinträchtigung der Beschäftigten, die mit diesen Substanzen in Kontakt kommen.

Die in der Resistschicht entstandenen strahlungsvernetzten, unlöslichen Zwischenprodukte unterliegen bei einer Temperung bei 200 bis 400°C einer Cyclisierung, wobei hochwärmebeständige Polymere der Stoffklasse der Polyimide gebildet werden. Für die Ausbildung hochwärmebeständiger Reliefstrukturen, auf Basis von Polyamidimiden oder Polyesterimiden ist das erfindungsgemäße Verfahren ebenfalls geeignet.

Diese hochwärmebeständigen Polymere haben ausgezeichnete chemische, elektrische und mechanische Eigenschaften. Fotolacke der beschriebenen Art eignen sich somit beispielsweise in besonderem Maße zur Herstellung von Schutzschichten z. B. bei der Herstellung von Halbleiterelementen, dielektrischen Schichten bei vielschichtigen integrierten Schaltungen, als letzte passivierende Schicht auf elektrischen Vorrichtungen sowie als Orientierungsschicht von Flüssigkristallanzeigezellen.

**Anwendungsbeispiele**

**Beispiel 1**:

a) Fotolack aus
5 g einer polymeren Polyimidvorstufe (erhalten durch Umsetzung von Pyromellithsäuredianhydrid mit 2-(Hydroxyethyl)-methacrylat und anschließend mit Thionylchlorid und 4,4'-Diaminodiphenylether gemäß DE PS 2437 348)
0,25 g N-Phenylmaleinimid
0,1 g Michlers Keton
0,05 g Vinyltrimethoxyethoxysilan gelöst in
10,5 ml N-Methylpyrrolidon
b) Der Fotolack gemäß (a) wird auf Substratproben mit $SiO_2$-Oberfläche aufgeschleudert und diese durch Erwärmen getrocknet. Die erhaltenen 1,0 µm starken Schichten werden anschließend unter Stickstoff im Kontaktverfahren durch ein Strichmuster mit einer 200 W Hg-Lampe mit einer Intensität von 9 - 10 mW/cm² belichtet. Die Belichtungsenergie wird von 960 mJ/cm² stufenweise bis auf 2400 mJ/cm gesteigert.
c) Anschließend werden die nicht belichteten Fotolackteile durch Entwickeln mit Cyclopentanon ausgewaschen und mit Isopropanol nachgespült. Man erhält kantenscharfe Bilder mit einer Auflösung von weniger als 3 µm.
Der Schichtdickenverlust der belichteten Fotolackteile durch den oben beschriebenen Prozeß ist abhängig von der Belichtungsenergie und nimmt mit zunehmender Belichtungsenergie ab:

| Belichtungsenergie | Schichtdickenverlust |
|---|---|
| 960 mJ/cm² | 70 % |
| 1250 " | 65 % |
| 1540 " | 60 % |
| 1830 " | 50 % |
| 2110 " | 45 % |
| 2400 " | 40 % |

**Vergleichsbeispiel**:

Unter den gleichen Bedingungen wie in Beispiel 1, jedoch unter Verwendung von 4-Butyrolacton/Toluol, 1 : 1 (Entwickler nach dem Stand der Technik), entsteht unabhängig von der Belichtungszeit ein Schichtdickenverlust von 70 %.

**Beispiel 2**:

a) Fotolack aus
5 g einer polymeren Polyimid-Vorstufe (nach Beispiel 1)
0,25 g N-Phenylmaleinimid
0,1 g Michlers Keton
0,05 g Vinyltrimethoxyethoxysilan
1 g 2,4,6-Trisallyloxy-1,3,5-triazin gelöst in 6,5 ml Dimethylformamid
b) Der Fotolack gemäß (a) wird wie in Beispiel 1 angegeben aufgeschleudert und belichtet, die Schichtdicke beträgt 7,3 µm.
c) Anschließend werden die nicht belichteten Fotolackteile durch Sprühentwicklung mit Cyclopentanon ausgewaschen und mit Isopropanol nachgespült.
Schichtdickenverlust und Auflösung werden durch Steigerung der Entwicklungszeit von 10 auf 50 Sekunden nicht beeinflußt.

**Vergleichsbeispiel**:

Unter den gleichen Bedingungen wie in Beispiel 2, jedoch unter Verwendung von 4-Butyrolacton/Toluol, 1 : 1, sind gut aufgelöste Strukturen nur bei Sprühentwicklungszeiten von 10 bis 15 Sekunden zu erhalten.

**Patentansprüche**

1. Verfahren zur Entwicklung von Reliefstrukturen auf der Basis von strahlungsvernetzten Polyimidvorstufen hochwärmebeständiger Polyimide mit einer Entwicklerflüssigkeit und gegebenenfalls nachfolgender Behandlung mit einer Spülflüssigkeit, dadurch gekennzeichnet, daß als Entwickler ein aliphatisches oder cycloaliphatisches Keton mit 3 bis 7 Kohlenstoffatomen in Abwesenheit eines Fällungsmittels verwendet wird.

2. Verfahren nach Anspruch 1, dadurch gekennzeichnet, daß als Entwickler Cyclopentanon und als Spülflüssigkeit ein aliphatischer Alkohol mit 1 - 4 Kohlenstoffatomen verwendet wird.

3. Verwendung eines aliphatischen oder cycloaliphatischen Ketons mit 3 bis 7 Kohlenstoffatomen als Entwickler für Reliefstrukturen auf der Basis von strahlungsvernetzten Polyimidvorstufen hochwärmebeständiger Polyimide.

4. Verwendung von Cyclopentanon nach Anspruch 3 als Entwickler.

5. Verwendung eines aliphatischen oder cycloaliphatischen Ketons mit 3 bis 7 Kohlenstoffatomen als Entwickler und eines aliphatischen Alkohols mit 1 bis 4 Kohlenstoffatomen als Spülflüssigkeit für ein Verfahren nach Anspruch 1.

**Claims**

1. Process for the development of relief structures based on radiation-crosslinked polymeric precursors of polyimides which are resistant to high temperature using a developer fluid and, where appropriate, subsequent treatment with a rinsing fluid, characterised in that the developer used is an aliphatic or cycloaliphatic ketone having 3 to 7 carbon atoms, in the absence of a precipitant.

2. Process according to Claim 1, characterised in that the developer used is cyclopentanone, and the rinsing fluid used is an aliphatic alcohol having 1 - 4 carbon atoms.

3. Use of an aliphatic or cycloaliphatic ketone having 3 to 7 carbon atoms as a developer for relief structures based on radiation-crosslinked polymeric precursors of polyimides which are resistant to high temperature.

4. Use of cyclopentanone as the developer according to Claim 3.

5. Use of an aliphatic or cycloaliphatic ketone having 3 to 7 carbon atoms as the developer, and an aliphatic alcohol having 1 to 4 carbon atoms as the rinsing fluid for a process according to Claim 1.

**Revendications**

1. Procédé pour le développement de structures en relief à base de prépolymères, réticulés sous l'action de radiations, de polyimides à haute stabilité à la chaleur à l'aide d'un liquide révélateur et le cas échéant traitement subséquent par un liquide de rinçage, caractérisé en ce que l'on utilise en tant que révélateur une cétone aliphatique ou cycloaliphatique contenant 3 à 7 atomes de carbone, non accompagnée d'un agent précipitant.

2. Procédé selon la revendication 1, caractérisé en ce que l'on utilise en tant que révélateur la cyclopentanone et en tant que liquide de rinçage un alcool aliphatique en C1-C4.

3. Utilisation d'une cétone aliphatique ou cycloaliphatique contenant 3 à 7 atomes de carbone en tant que révélateur pour des structures en relief à base de prépolymères, réticulés sous l'action de radiations, de polyimides à haute stabilité à la chaleur.

4. Utilisation selon la revendication 3 de la cyclopentanone en tant que révélateur.

5. Utilisation d'une cétone aliphatique ou cycloaliphatique contenant 3 à 7 atomes de carbone en tant que révélateur et d'un alcool aliphatique contenant 1 à 4 atomes de carbone en tant que liquide de rinçage dans un procédé selon la revendication 1.